Europäisches Patentamt

European Patent Office

Office européen des brevets

(11) Publication number: **0 032 608**
**A1**

# EUROPEAN PATENT APPLICATION

(21) Application number: 80300205.4

(22) Date of filing: 22.01.80

(51) Int. Cl.³: **G 11 C 11/40, H 01 L 27/02, H 01 L 27/10, H 01 L 27/06, H 03 K 3/356**

(43) Date of publication of application: **29.07.81**
**Bulletin 81/30**

(84) Designated Contracting States: **BE CH DE FR IT NL SE**

(71) Applicant: **MOSTEK CORPORATION, 1215 West Crosby Road, Carrollton Dallas, Texas 75006 (US)**

(72) Inventor: **Parkinson, Ward D., 7337 Northview, Boise, Idaho 83704 (US)**

(74) Representative: **Broome, Geoffrey Edward, KILBURN & STRODE 30 John Street, London, WC1N 2DD (GB)**

(54) **Column line powered static ram cell.**

(57) A column line powered static random access memory (RAM) cell and a group of four mutually contiguous cells in an array of memory cells is disclosed. A common resistor supply node which is required in a prior art static RAM cell wherein it is centrally disposed within the group is deleted in the structural layout as disclosed in the present invention. The common source node remains, which is the ground line. In order to replace the common resistor supply node to which resistors are attached, the present invention discloses that the resistors are connected to a DATA line on a first cell, and to a $\overline{DATA}$ line on a second cell. Alternatively, these resistors can be connected to a $\overline{DATA}$ line and then respectively to a DATA line. A third alternative is where one resistor is connected to the $\overline{DATA}$ line and one resistor is connected to the DATA line. In a preferred embodiment, the principal components of each cell include a plurality of insulated gate field-effect transistors, each having a source diffusion region and a drain diffusion region formed within the substrate and a plurality of impedance devices electrically connecting the column lines to the drain diffusion of the transistors in each cell. The impedance devices extend radially from the column lines into the interior of each cell, and at least one of the diffused regions of each transistor in each cell is formed in common with a diffused region of a transistor of a contiguous cell.

1.

## COLUMN LINE POWERED STATIC RAM CELL

BACKGROUND OF THE INVENTION

The present invention is concerned with random access memories of the type fabricated on a monolithic semiconductor chip using insulated gate semiconductor field-effect transistor technology, and more particularly relates to an improved structural layout for the principal components of each cell of an integrated circuit memory.

DESCRIPTION OF THE PRIOR ART

Large scale integration (LSI) techniques have brought about the construction of large arrays of binary storage elements on a single chip of silicon. These storage cells, typically using MOS technology, consist of multi-component circuits in a conventional bistable configuration. The immediate advantages of such semiconductor storage devices are the high packing density and low power requirements. The insulated gate MOS transistor has served well in this application area since it requires less substrate area (thereby increasing the packing density) and operates at very low power levels.

A well known memory cell circuit arrangement which utilizes insulated gate MOS field-effect transistors is the cross-coupled inverter stage as disclosed in U. S. Patent 3,967,252. In that arrangement the gates of a pair of insulated gate MOS field-effect transistors are cross coupled to a true data node, referred to as the DATA node, and a complementary data node, commonly designated as the $\overline{\text{DATA}}$ node. Binary information stored within the cell is maintained by impedance means which are connected to the data nodes to maintain the potential at the gate of the transistors at a predetermined level which corresponds to the logic content of the cell.

In the static random access memory cells shown in U. S. Patent 3,967,252, there are two cross-coupled inverters comprising two load devices and four transistors. In an effort to minimize the substrate area required for a given number of memory cells, the two load devices in the static cell of each inverter have been fabricated as an integral portion of a polycrystalline silicon strip which interconnects a common drain supply node with a data node as disclosed and claimed in United States Patent No. 4,125,854, and assigned to a common assignee. United States Patent 4,125,854 is incorporated herein by reference.

There remains considerable interest in minimizing the dimensions of the cell structure of integrated circuit memories to provide improved performance and higher packing density.   One prior art approach for minimizing the dimensions of a conventional cross-coupled inverter stage is illustrated in Figure 3 of the drawing shown in United States Patent No. 4,125,854.   In that arrangement, shared diffusion regions interconnect the principal components of the cell to corresponding components of adjacent cells in the same row or in the same column.   Also, a pair of cells in a single column are energized from a common drain supply node.  An object of the application issued as United States Patent No. 4,125,854 is to provide an improved structural layout for the principal components of each cell so that the shared diffusion regions and the common power supply nodes may be utilized more efficiently.

A related object of the present invention is to delete one of the power supply nodes found in all static memory cells by connecting the resistors fabricated as an integral part of the poly (i.e. polysilicon) interconnect to the data (column) lines rather than to a $V_{DD}$ line, allowing deletion of that $V_{DD}$ line running through the cell and thus allowing substantial reduction in each

3.                          0032608

cell area.

SUMMARY OF THE INVENTION

Accordingly the present invention provides an integrated circuit memory comprising, in combination, a substrate of semiconductor material of a first conductivity type; an array of memory cells fabricated on the substrate in rows and columns; each cell of the array including first and second data storage transistors, first and second enabling transistors, and first and second impedance devices having first and second nodes, each of the transistors having a gate, and source and drain diffusion regions formed in the substrate; the gate of the second data storage transistor being electrically connected to the drain diffusion of the first data storage transistor, to the drain diffusion of the first enabling transistor, and to the first node of the first impedance device thereby defining a first data node in each cell of the array; the gate of the first data storage transistor being electrically connected to the drain diffusion of the second data storage transistor, to the drain diffusion of the second enabling transistor, and to the first node of the second impedance device thereby defining a second data node in each cell of the array; the drain diffusion of the first data storage transistor being formed in common with the drain diffusion of the first enabling transistor of each cell of the array; the array including a first group of four of the cells disposed in mutual contiguous relation to each other in a first row and in a second row adjacent to the first row, and in a first column and in a second column adjacent to the first column; the source diffusions of the second

4. 0032608

data storage transistors of contiguous cells in the first and second rows of the first group being formed in common, respectively; and, the second nodes of the first and second impedance devices being connected to any of the sources of the enabling transistors.

In a further aspect the invention provides an integrated circuit memory of the type including an array of memory cells fabricated on a semiconductor substrate in rows and columns, each cell including principal components interconnected to store bits of binary data including first and second impedance devices having first nodes connected to the internal data storage nodes and second voltage nodes for the supply of voltage to the memory cell, an improved structural layout for the principal components of each cell in a group of four mutually contiguous cells of the array comprising: a common impedance node, formed by the interconnection of the second nodes of the first and second impedance devices connected to at least one of the data lines disposed substantially in the geometrical center of the group as defined by the intersection of a first centerline axis and a second centerline axis disposed substantially perpendicular to the first axis; and corresponding components of contiguous cells in each row of the group being symmetrically disposed with respect to each of the first and second axes.

In a further aspect the invention provides an integrated circuit memory comprising a substrate of semiconductor material doped with impurities of a first conductivity type; an array of memory cells fabricated on the substrate in input rows and output columns; the substrate within each cell of the array including first and second pairs of active surface areas surrounded by a substrate field area, the first pair being the situs of first and second data storage transistors, and the second pair being the situs of first and second enabling transistors; a strip of gate insulating material disposed over a portion of each active situs area; a diffusion of impurities of the opposite conductivity type disposed in the substrate beneath each active surface area on either side of the gate insulating strip thereby forming source and drain diffusion regions for each transistor, a nondiffused channel region being defined in the active substrate area beneath the gate insulating strip and between the source and drain diffusion regions, the source and drain diffusion regions of each transistor extending through the surrounding field regions of the substrate for predetermined distances; a first layer of electrical insulating material being disposed over the substrate field area of each cell and around but not over the active situs area of each cell; a conductive gate strip deposited on each gate insulating strip, the conductive gate strips extending transversely with respect to the associated source and drain regions and across the surrounding field insulation; the conductive gate strips of the first and second enabling transistors of each cell of each input row being formed in common thereby defining a common row address line for each input row; the source diffusions of the first and second enabling transistors of each cell in a selected row being formed in common with the source diffusions of the first and second enabling transistors of contiguous cells of an adjacent row respectively; the conductive gate strips of the first and second data storage transistors of each cell extending transversely with respect to the associated diffused source and drain regions across the field insulation and being disposed in electrical contact with the drain diffusions of the second and first enabling transistors, respectively, and in electrical contact with the drain diffusions of the second and first data storage transistors of the same cell, respectively; first and second impedance means each having a first and second terminal portion, the first terminal portion being electrically connected to the drain diffusions of the first and second data storage transistors of each cell, respectively, thereby defining a first and second data node in each cell, the second terminal portions of the impedance means in each cell of a first group of four mutually contiguous cells being electrically connected together to define a common impedance node connected to one of the $\overline{data}$ or data lines common to a column of cells; the source diffusions of the first data storage transistors of each cell in a second group of four mutually contiguous cells being formed in common thereby defining a first common source supply node, the cells of the second group being disposed in the adjacent rows in which the cells of the first group are disposed, one cell in each row being common to each of the first and second selected groups; the drain diffusion of the first data storage transistor of each cell being formed in common with the drain diffusion of the first enabling transistor of each cell; the source diffusion of the second data storage transistor of each cell being formed in common with the source diffusion of the second data storage transistor disposed in the contiguous cell of the same row and adjacent column thereby defining a second source supply node; a second insulating layer deposited over the first insulating layer, the row address lines, gate strips and impedance devices; a first conductive strip deposited over the second insulating layer and extending transversely with respect to the row address lines across each row of cells, the first conductive strip being electrically connected to each of the first common source supply nodes defined by a plurality of the second groups, the mutually contiguous cells of each of the second groups being disposed in adjacent columns, thereby defining a first source supply line common to each cell in adjacent columns containing the second groups; a second conductive strip deposited over the second insulating layer and extending across each row of cells substantially parallel to the first conductive strip, the second conductive strip being electrically connected to the common source diffusions of first enabling transistors of contiguous cells in the column thereby defining a common data output line for each of the cells in the column, and also connected to the common impedance node defining a means of providing cell power without a line used only as a power supply; a third conductive strip deposited over the second insulating layer and extending across each row of cells substantially parallel to the second conductive strip, the second conductive strip being electrically connected to each of the common source diffusions of the second enabling transistors of contiguous cells in the column thereby defining a common data complement output line for each of the cells in the column; a fourth conductive strip deposited over the second insulating layer and extending across each row of cells of the array and substantially parallel to the third conductive strip, the fourth conductive strip being electrically connected to each of the second source supply nodes of each cell in the column thereby defining a second source supply line common to each cell in the column.

A further reduction in the physical size of a memory cell for an integrated circuit memory can be accomplished by connecting the resistors to the data (column) lines, eliminating the need for the positive power supply line, $V_{DD}$, which is routed to all of the memory cells in prior art static RAM cell layouts. The cell of the present invention still remains symmetrical about the first and second mutually perpendicular axis of symmetry, allowing sharing of data (column) contacts between mutually adjacent cells. In addition, data (column) lines contact multiple load resistors to the cells, eliminating the need for the positive power supply $V_{DD}$.

The novel features which characterize the present invention are

defined by the appended claims. The foregoing and other objects, advantages and features of the present invention will hereinafter appear, and for purposes of illustration of the invention, but not of limitation, an exemplary embodiment of the invention is shown in the appended drawings.

BRIEF DESCRIPTION OF THE DRAWINGS

FIGURE 1 is a block circuit diagram of a portion of a random access memory which utilizes a memory cell constructed according to the teachings of the present invention;

FIGURE 2 is an electrical circuit diagram of a memory cell which is representative of the prior art;

FIGURE 3 is an electrical circuit diagram of the memory cell shown in FIGURE 1 and shows one embodiment of the present invention;

FIGURE 4 is an electrical circuit diagram of the memory cell shown in FIGURE 1 and shows a second embodiment of the present invention;

FIGURE 5 is an electrical circuit diagram of the memory cell shown in FIGURE 1 and shows a third embodiment of the present invention;

FIGURE 6 is an electrical circuit diagram of the memory cell shown in FIGURE 1 and shows a fourth embodiment of the present invention;

FIGURE 7 is a partial substrate layout diagram showing a grouping of memory cells; and,

FIGURE 8 is an elevation view, in sections, taken along the line VIII–VIII of FIGURE 7.

DETAILED DESCRIPTION

In the description which follows, the present invention is described in combination with a random access memory of the type utilizing insulated gate field-effect transistor technology. The structure as disclosed herein may be fabricated on a single semiconductor chip and is primarily intended for such fabrication.

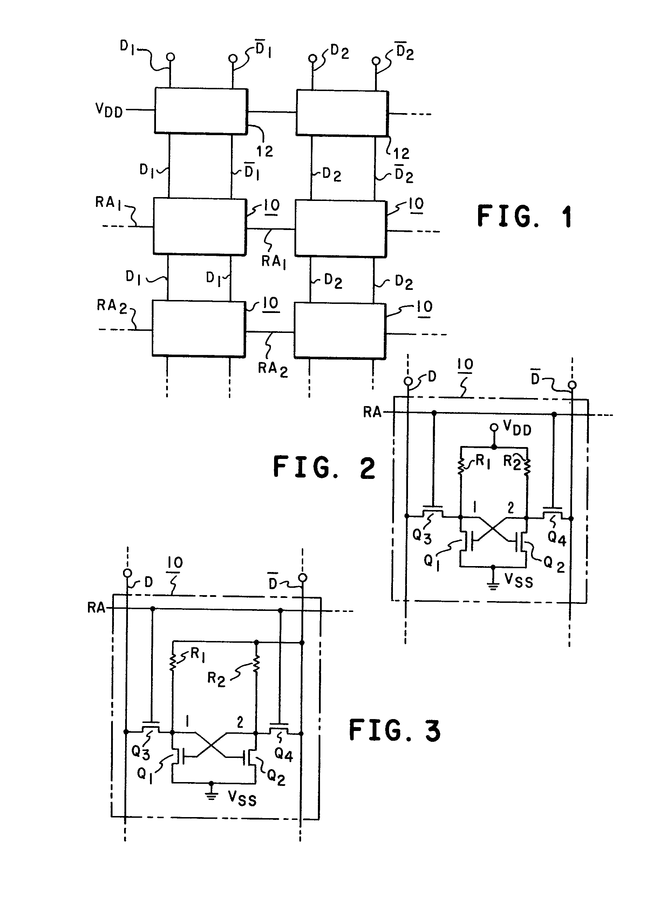

Referring now to FIGURE 1 and FIGURE 3 of the drawings, a portion of a random access memory which utilizes circuitry constructed according to the teachings of the present invention is illustrated. In FIGURE 1, a portion of a random access memory includes a plurality of static memory cells 10 which are part of an array of many such cells arranged in rows and columns in the conventional manner. The memory cells 10 are disposed in separate columns and accordingly connected to separate complementary data buses $D_1$, $\bar{D}_1$ and $D_2$, $\bar{D}_2$. Since the memory cells are disposed in separate rows, the rows are addressed or enabled by separate row address lines $RA_1$ and $RA_2$, respectively. The row address line $RA_1$ enables all the memory cells in a second row.

$RA_1$ and $RA_2$ are mutually exclusive in that only one row of memory cells is selected at one time.

A sense amplifier is indicated generally by the reference numeral 12 and is connected to the output of each of the columns. The sense amp 12 may be of any conventional type, for example, that which is disclosed and claimed by U. S. Patent 3,967,252. Write control circuits (not shown) may be connected to drive the column buses during a write cycle in the conventional manner. Column enable means (not shown) may be provided to connect different pairs of column buses to a single sense amp, or a separate sense amp may be provided for each pair of column buses.

One of the main differences in allowing implementation of this proposed new cell is that the write control circuits used must be different than those in the conventional manner in the sense that when writing the memory cell, any given DATA or $\overline{\text{DATA}}$ line must be held low in the write mode for a small percentage of the duty cycle. Namely, the $\overline{\text{DATA}}$ and DATA lines would normally be held high near $V_{DD}$, the positive supply voltage, and during the write mode, one would be briefly brought low, rather than indefinitely brought low, as on a conventional write circuit. This is commonly referred to in the art as pulsing the data or $\overline{\text{DATA}}$ lines when attempting to "write" or input data to a selected cell. If the data and $\overline{\text{DATA}}$ lines are brought low, for example, for 50 nanoseconds, and the internal time constant on node 1 and node 2 is on the order of a millisecond due to the use of very high valued resistors (such that the time constant of $R_1$ times capacitance on node 1 is very long compared with the time that the DATA or $\overline{\text{DATA}}$ lines are brought low), then the nonselected cells will not be affected by the writing of the selected cell in the memory matrix.

An electrical schematic diagram of the memory cell 10 is illustrated in FIGURES 3, 4, 5 and 6 of the drawings. The binary memory cell 10 comprises first and second complementary data input nodes D and $\bar{D}$

(DATA and $\overline{\text{DATA}}$) which provide a direct current impedance path and a relatively higher direct current impedance path corresponding to each binary logic state.    First and second impedance means $R_1$ and $R_2$ electrically connect a source of current to the internal data nodes 1 and 2 from the column lines D and $\overline{D}$ which are held high, near $V_{DD}$ in voltage, by the sense amps.  This provides a means of continuous power allowing the cells to be static in the sense that nonoperation of the cells or non-exercising (non-refreshing) of the cells will result in the cells retaining the previously written data, without a need for refreshing the cells periodically.  This characterizes a static cell as compared to a dynamic cell.

The structure of the impedance means $R_1$ and $R_2$ is described in detail in United States Patent No. 4,125,854, which patent is hereby incorporated by reference.  The memory cell 10 also includes a pair of cross-coupled insulated gate field-effect data storage transistors $Q_1$ and $Q_2$, respectively, and are connected by enabling transistors $Q_3$ and $Q_4$ that are connected to the corresponding row of address lines RA.  The channel between the drain and source terminals of transistors $Q_1$ and $Q_2$ electrically connect nodes 1 and 2 to a source node $V_{SS}$ when conducting.

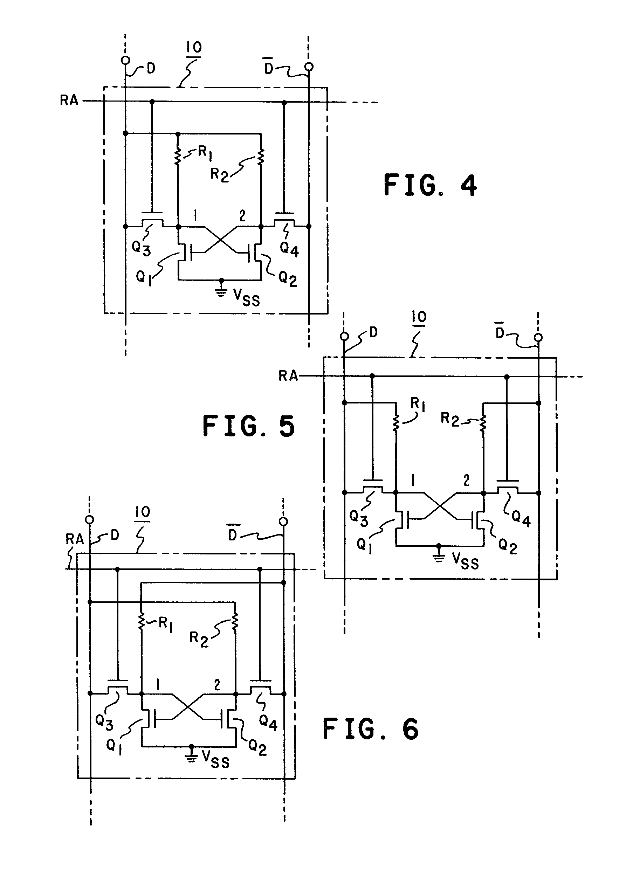

In the operation of the cells of FIGURES 3, 4 and 5, the row address line RA is low (logic "0") so that the enabling transistors $Q_3$ and $Q_4$ of the memory cell 10 which are connected to the row address line RA are turned off.  This allows the column lines D and $\overline{D}$ to have a voltage level substantially equal to $V_{DD}$, because there are no current paths to the source voltage $V_{SS}$ other than through the very high valued resistors $R_1$ and $R_2$.  In a typical circuit, $V_{DD}$ may be five (5) volts, in which case the column lines D and $\overline{D}$ would be about five volts.  In this state, current will flow through the column lines D and/or $\overline{D}$ into the standby resistors $R_1$ and $R_2$ of each cell respectively in which cell load resistors are connected to that respective D (DATA) or $\overline{D}$ ($\overline{\text{DATA}}$) line.  On a given column line, one-half of the cells are connected to the $\overline{\text{DATA}}$ line (as represented in FIGURE 3), and the other half of the cells are connected to the DATA line (as represented in FIGURE 4), to equalize the standby current from the D and $\overline{D}$ lines.

Assume that a logic "0" has been stored in the memory cell 10

12. 0032608

so that the transistor $Q_2$ is turned off and data node D is substantially at $V_{DD}$. Then when the row address line RA goes high, that is, is raised to a bias potential corresponding to a logic "1", the memory cell 10 is selected by the "turn on" of transistors $Q_3$ and $Q_4$. This results in a current path to $V_{SS}$ through the transistors $Q_1$ and $Q_3$ and the column line D. The transistor $Q_2$ is turned off so that no current path is established from the column line $\bar{D}$ to ground, except through very high impedance standby resistors. As a result, the data node $\bar{D}$ remains substantially at $V_{DD}$, while node D is being discharged low through $Q_3$ and $Q_1$. This allows sensing of the correct state of the cell. If, on the other hand, a logic "1" is stored in the address of the memory cell 10, transistors $Q_1$ and $Q_3$ are off and $Q_2$ and $Q_4$ are on, discharging the $\bar{D}$ line rather than D line, allowing the reverse state of the cell to be sensed. It is important in the read mode that the $\bar{D}$ and D discharge levels during readout of the cell be controlled so that nodes D and $\bar{D}$ do not fully discharge to $V_{SS}$ for substantial periods of time in that this would tend to write all other cells in the column to the readout state of the selected cell on the column. This is accomplished by insuring that the read cycle is limited in the respect that nodes D and $\bar{D}$ discharge less than 50% of the precharge value of $V_{DD}$. In this way, there is always a positive supply for the non-selected cells, providing standby current to retain previously written data.

To write the cell, it is necessary that nodes D or $\bar{D}$, namely DATA and $\overline{DATA}$ lines, are brought low near $V_{SS}$, forcing low one of the two internal cross-coupled nodes 1 or 2, depending respectively on whether it is node D or $\bar{D}$ that is brought low during the write cycle. Specifically, if node D is brought low when node 1 is high, transistor $Q_3$ will turn on, pulling node 1 low, allowing transistor $Q_4$ to pull node 2 high, forcing $Q_1$ on and $Q_2$ off. When RA is then returned to $V_{SS}$, deselecting the cell, or D is returned high to $V_{DD}$, the cell retains the state written into it, since $R_2$ will provide the current necessary to keep node 2 high, forcing $Q_1$ to remain on, which forces node 1 to be low, keeping $Q_2$ off. In this manner, there is cell data retention in a static manner with standby power supplied by the column lines through $R_1$ and $R_2$.

In the process of writing the cell, again a DATA or $\overline{DATA}$ line is brought low. This condition, if maintained indefinitely, would write other cells on the column and must be limited to short time periods relative to the internal time constant of the cell. If, for example, $R_1$ is a high valued resistor on the order of 100 megohms and the internal capacitance on node 1 of the cell is 0.1 pico-farad, the time constant of node 1 or 2 would be very long compared to the necessary write time of the cell when node D or $\bar{D}$ is brought low, by several orders of magnitude.

The foregoing procedure allows the selected cell to be safely written without writing other cells that are not selected on the column line, and allows elimination of the $V_{DD}$ line that transverses the cell as a connection to resistors $R_1$ and $R_2$. Specifically referring to United States Patent No. 4,125,854, $V_{DD}$ as shown in FIGURES 3, 4, 5 and 6 of said patent application has now been eliminated and the connections through contacts 42 are made with D or $\bar{D}$. Eliminating $V_{DD}$ in this manner allows the memory cell area to be substantially reduced with favorable improvements in the cost of production and allows fabrication of integrated circuit memories with greater bit densities.

In one preferred embodiment of the present invention there is provided an integrated circuit memory comprising a substrate of semiconductor material of a first conductivity type; an array of memory cells fabricated on the substrate in rows and columns; each cell of the array including first and second data storage transistors, first and second enabling transistors, and first and second impedance devices, each of the transistors having a gate, a source diffusion region, and a drain diffusion region formed in the substrate; the gate of the second data storage transistor being electrically connected to the drain diffusion of the first data storage transistor, to the drain diffusion of the first enabling transistor, and to the first impedance device thereby defining a first data node in each cell of the array; the gate of the first data storage transistor being electrically connected to the drain diffusion of the second data storage transistor, to the drain diffusion of the second enabling transistor, and to the second impedance device thereby defining a second data node in each cell of the array; the drain diffusion of the first data storage transistor being formed in common with the drain diffusion of the first enabling transistor in each cell of the array; the drain diffusion of the second storage transistor being formed in common with the drain ofthe second enabling transistor in each cell of the array; the array including a first group of four of the cells disposed in mutually contiguous relation to each other in a first row and in a second row adjacent to the first row, and in a first column and in a second column adjacent to the first column; the source diffusions of the second data storage transistors of contiguous cells in the first and second rows of the first group being formed in common, respectively; and at least one of the first and second impedance devices of each cell of the first group being electrically connected to the source of at least one of the enabling transistors.

The impedance devices are electrically connected in several different embodiments such as (1) wherein both of the first and second impedance devices are electrically connected to the source of the first enabling transistor (see FIGURE 4); (2) wherein both of the first and second impedance devices are electrically connected to the source of the second enabling transistor (see FIGURE 3); (3) wherein the first impedance device is electrically connected to the source of the first enabling transistor and the second impedance device is electrically connected to the source of the second enabling transistor (see FIGURE 5); and (4) wherein the first impedance device is electrically connected to the source of the second enabling transistor and the second impedance device is electrically connected to the source of the first enabling transistor (see FIGURE 6).

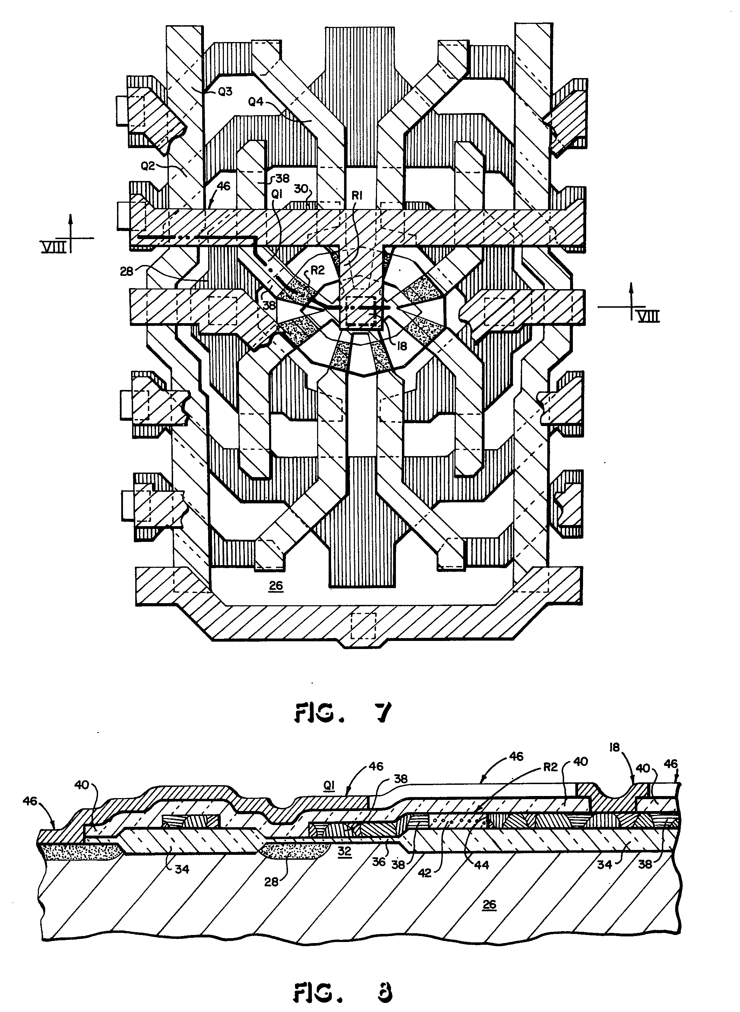

Referring now to FIGURE 7, a substrate layout of a grouping of four mutually contiguous memory cells is illustrated. The common impedance node 18 is connected to the complement data line $\bar{D}$. The complete absence of a power supply to the common impedance node 18 should be noted.

The memory cell 10 is disposed upon a substrate 26 of an extrinsic semiconductor material of a first conductivity type, for example, P-type monocrystalline silicon. Each of the field-effect transistors $Q_1$ – $Q_4$ include a source region 28 and a drain region 30 (FIGURES 7, 8) in which impurities of the opposite conductivity type, for example, N-type, have been diffused and extend substantially parallel to each other in the conventional manner through an active region 32 of the substrate 26. A layer 34 of field insulation is disposed over the surface of the substrate 26 and is formed in a relatively thin layer 36 in the gate zone which lies directly over the active region 32. A diffused polysilicon layer 38 serves as a gate interconnect portion for the transistor $Q_1$ formed over the active region 32. A layer 40 of the electrical insulation, preferably oxide, is formed over the gate strip 38 and over the field insulation 34.

The semiconductor material which forms the conductive gate strip 38 is the same elemental semiconductor type as is the substrate 26, and is preferably constructed of a continuous layer of polycrystalline silicon. Extrinsic impurities are diffused within the gate strip 38 and may be either N-type or P-type. In a preferred embodiment, the extrinsic impurities diffused into the gate strip 38 are of the opposite conductivity type relative to the conductivity type of the substrate 26. For example, for a P-type substrate 26, the impurities diffused into the gate strip 38 are N-type, so that the diffusion of the gate strip 38, source and drain regions 28, 30 and impedance devices $R_1$ and $R_2$ may all be formed during a single diffusion step of an isoplanar silicon gate process.

Each of the load impedance devices $R_1$ and $R_2$ include a body 42 of substantially pure intrinsic semiconductor material defining a series conductive path within the polysilicon gate strip 38. An intrinsic-extrinsic junction 44 is defined by the interface of the diffused gate strip 38 and the undiffused intrinsic body 42. Each series path formed by the composit resistor/gate strip interconnects the data lines $\bar{D}$, D (FIG. 3, 4 respectively) to the corresponding data nodes 1, 2. As used herein, the phrase "intrinsic semiconductive material" means elemental semiconductor material which is undoped and which has not been diffused or otherwise implanted with impurities.

The connection of the common impedance node 18 to the $\overline{DATA}$ line comprises a metallization deposit 46 which is bonded directly to the oxide layer 40.

In conjunction with the embodiments described hereinbefore, it is preferred that the structural layout include the common impedance node 18 disposed substantially in the geometrical center of the first group of cells, the first and second load impedance devices $R_1$ and $R_2$ of each cell extending radially from the common impedance node to the interior of the cell.

In conjunction with the embodiments described hereinbefore, it

16. 0032608

is preferred that the structural layout be such wherein each of the first and second impedance means $R_1$ and $R_2$ of each cell is formed as an integral portion of the polycrystalline silicon strip 38 which interconnects the common impedance node 18 to the corresponding first and second internal cell nodes "1" and "2", respectively, each impedance means including a body of substantially pure polycrystalline silicon 42 defining a first conductive path and a diffusion of impurities of the opposite conductivity type disposed within a region of the body defining a second conductive path, a diffused-nondiffused junction 44 being defined by the interface of the diffused region with the substantially pure polycrystalline silicon body, the first and second paths defining a series electrical path from the common impedance node 18 to the corresponding internal cell node.

CLAIMS:

1.    In    an    integrated    circuit    memory    comprising,    in combination:

a substrate of semiconductor material of a first conductivity type;

an array of memory cells fabricated on the substrate in rows and columns;

each cell of the array including first and second data storage transistors, first and second enabling transistors, and first and second impedance devices having first and second nodes, each of the transistors having a gate, and source and drain diffusion regions formed in the substrate;

the gate of the second data storage transistor being electrically connected to the drain diffusion of the first data storage transistor, to the drain diffusion of the first enabling transistor, and to the first node of the first impedance device thereby defining a first data node in each cell of the array;

the gate of the first data storage transistor being electrically connected to the drain diffusion of the second data storage transistor, to the drain diffusion of the second enabling transistor, and to the first node of the second impedance device thereby defining a second data node in each cell of the array;

the drain diffusion of the first data storage transistor being formed in common with the drain diffusion of the first enabling transistor of each cell of the array;

the array including a first group of four of the cells disposed in mutual contiguous relation to each other in a first row and in a second row adjacent to the first row, and in a first column and in a second column adjacent to the first column;

the source diffusions of the second data storage transistors of contiguous cells in the first and second rows of the first group being formed in common, respectively; and,

the second nodes of the first and second impedance devices being connected to any of the sources of the enabling transistors.

2. The memory as set forth in Claim 1 wherein both of the second nodes of the first and second impedance devices are electrically connected to the source of the first enabling transistor.

3. The memory as set forth in Claim 1 wherein both of the second nodes of the first and second impedance devices are electrically connected to the source of the second enabling transistor.

4. The memory as set forth in Claim 1 wherein the first impedance device is electrically connected to the source of the first enabling transistor and the second impedance device is electrically connected to the source of the second enabling transistor.

5. The memory as set forth in Claim 1 wherein the first impedance device is electrically connected to the source of the second enabling transistor and the second impedance device is electrically connected to the source of the first enabling transistor.

6. The integrated circuit memory as defined in/Claim any preceding wherein the common impedance node formed by the interconnection of the second nodes of the first and second impedance devices is disposed substantially in the geometrical center of the first group of cells, the first and second impedance devices of each cell extending radially from the common impedance node to the interior of the cell.

7. The integrated circuit memory as defined in Claim 6 wherein each of the first and second impedance means of each cell is formed as an integral portion of a polycrystalline strip which interconnects the common impedance node to the corresponding first and second internal cell nodes, respectively, each impedance means including a body of substantially pure polycrystalline silicon defining a first conductive path and a diffusion of impurities of the opposite conductivity type disposed within a region of the body defining a second conductive path, a diffused-nondiffused junction being defined by the interface of the diffused region with the substantially pure polycrystalline silicon body, the first and second paths defining a series electrical path from the common impedance node formed by the interconnection of the second nodes of the first and second impedance devices to the corresponding internal cell node.

8.      The integrated circuit memory as defined in Claim 1, the array including an additional group of four mutually contiguous cells identical to the first group contiguously disposed in the first and second rows and in the first and second columns on each side of the first group;

the source diffusions of the first and second enabling transistors of each cell in the first and second columns and first row of the first group being formed in common with the source diffusions of the first and second enabling transistors of corresponding cells of the contiguous group of cells disposed in the first and second columns and in the row immediately preceding the first row;

the source diffusions of the first and second enabling transistors of each cell in the first and second columns and the second row of the first group being formed in common with the source diffusions of the first and second enabling transistors of corresponding cells of the contiguous group of cells disposed in the first and second columns and in the row immediately succeeding the second row; -

the source diffusions of the first data storage transistors of the adjacent cells of the first group disposed in the first and second rows and in the first column being formed in common, respectively, with the source diffusions of the first data storage transistors of corresponding cells of the contiguous group of cells disposed in the first and second rows and in the column immediately preceding the first column of the first group;

the source diffusions of the first data storage transistors of the adjacent cells of the first group disposed in the first and second rows and in the second column being formed in common, respectively, with the source diffusions of the first data storage transistors of corresponding cells of the contiguous group of cells disposed in the first and second rows and in the column immediately succeeding the second column of the first group;

the gates of the first and second enabling transistors of each cell of the first group disposed in the first row being formed in common with each other and with the gates of the corresponding enabling transistors disposed in the first row of the contiguous groups immediately preceding and succeeding the first group thereby defining a first row address line common to each cell in the first row of the array; and

the gates of the first and second enabling transistors of each cell of the first group disposed in the second row being formed in common with each other and with the gates of the corresponding enabling transistors disposed in the second row of the contiguous groups immediately preceding and succeeding the first group thereby defining a second row address line common to each cell in the second row of the array.

9.    The integrated circuit memory as defined in Claim 8 including:

a first conductive strip extending transversely with respect to the common row address lines across each row of cells, the first conductive strip being electrically connected to the common source diffusions of the first data storage transistors disposed in adjacent columns of contiguous groups thereby defining a first source supply line for each pair of contiguous columns of groups,

a second conductive strip extending transversely with respect to the common row address lines across each row of cells, the second conductive strip being electrically connected to the common source diffusions of the second data storage transistors in each group thereby defining a second source supply line for each column of groups;

a third conductive strip extending transversely with respect to the common row address lines across each row of cells, the third conductive strip being electrically connected to the first enabling transistor source of each cell of each column thereby defining a first data output line common to each cell of each column, and also connected to the common impedance node formed by the interconnection of the second nodes at the first and second impedance devices defining a means of providing cell standby power without a line used only as a positive supply; and

a fourth conductive strip extending transversely with respect to the common row address lines across each row of cells, the fourth conductive strip being electrically connected to the second enabling

0032608

transistor source of each cell of each column thereby defining a second data output line common to each cell of each column.

10. In an integrated circuit memory of the type including an array of memory cells fabricated on a semiconductor substrate in rows and columns, each cell including principal components interconnected to store bits of binary data including first and second impedance devices having first nodes connected to the internal data storage nodes and second voltage nodes for the supply of voltage to the memory cell, an improved structural layout for the principal components of each cell in a group of four mutually contiguous cells of the array comprising:

a common impedance node, formed by the interconnection of the second nodes of the first and second impedance devices connected to at least one of the data lines disposed substantially in the geometrical center of the group as defined by the intersection of a first centerline axis and a second centerline axis disposed substantially perpendicular to the first axis; and

corresponding components of contiguous cells in each row of the group being symmetrically disposed with respect to each of the first and second axes.

11. The combination as defined in Claim 10 wherein each cell includes as principal components a plurality of insulated gate field–effect transistors each having a source diffusion and a drain diffusion formed in the substrate, at least one of the diffused regions of each transistor being formed in common with a diffused region of another transistor of a contiguous cell.

12. The combination as defined in Claim 11, including first and second insulated gate field–effect data storage transistors and first and second insulated gate field–effect enabling transistors, the source diffusions of the first data storage transistors of column contiguous cells being formed in common, the source diffusions of the second data storage transistors of row contiguous cells being formed in common, and the drain diffusions of the first data storage transistor and the first enabling transistor being formed in common in each cell.

13.    The combination as defined in Claim 12, wherein the gate of the first data storage transistor is electrically connected to the drain diffusion of the second enabling transistor and to the drain diffusion of the second data storage transistor thereby defining a first data node, the gate of the second data storage transistor being electrically connected to the drain diffusion of the first enabling transistor and to the drain diffusion of the first data storage transistor thereby defining a second data node, the combination further including first and second impedance devices in each cell of the group of four mutually contiguous cells, each of the impedance devices electrically connecting the common impedance node to the first and second data nodes, respectively, of each cell.

14.    The combination as defined in Claim 13 wherein each impedance device extends radially from the common impedance node, at least one impedance device of each cell being angularly displaced with respect to the axes by an angle measuring less than a right angle.

15.    An integrated circuit memory comprising:

a substrate of semiconductor material doped with impurities of a first conductivity type;

an array of memory cells fabricated on the substrate in input rows and output columns;

the substrate within each cell of the array including first and second pairs of active surface areas surrounded by a substrate field area, the first pair being the situs of first and second data storage transistors, and the second pair being the situs of first and second enabling transistors;

a strip of gate insulating material disposed over a portion of each active situs area;

a diffusion of impurities of the opposite conductivity type disposed in the substrate beneath each active surface area on either side of the gate insulating strip thereby forming source and drain diffusion regions for each transistor, a nondiffused channel region being defined in the active substrate area beneath the gate insulating strip and between the source and drain diffusion regions, the source and drain diffusion regions of each transistor extending through the surrounding field regions of the substrate for predetermined distances;

a first layer of electrical insulating material being disposed over the substrate field area of each cell and around but not over the active situs area of each cell;

a conductive gate strip deposited on each gate insulating strip, the conductive gate strips extending transversely with respect to the associated source and drain regions and across the surrounding field insulation;

the conductive gate strips of the first and second enabling transistors of each cell of each input row being formed in common thereby defining a common row address line for each input row;

the source diffusions of the first and second enabling transistors of each cell in a selected row being formed in common with the source diffusions of the first and second enabling transistors of contiguous cells of an adjacent row respectively;

the conductive gate strips of the first and second data storage transistors of each cell extending transversely with respect to the associated diffused source and drain regions across the field insulation and being disposed in electrical contact with the drain diffusions of the second and first enabling transistors, respectively, and in electrical contact with the drain diffusions of the second and first data storage transistors of the same cell, respectively;

first and second impedance means each having a first and second terminal portion, the first terminal portion being electrically connected to the drain diffusions of the first and second data storage transistors of each cell, respectively, thereby defining a first and second data node in each cell, the second terminal portions of the impedance means in each cell of a first group of four mutually contiguous cells being electrically connected together to define a common impedance node connected to one of the data or data lines common to a column of cells;

the source diffusions of the first data storage transistors of each cell in a second group of four mutually contiguous cells being formed in common thereby defining a first common source supply node, the cells of the second group being disposed in the adjacent rows in which the cells of the first group are disposed, one cell in each row being common to each of the first and second selected groups;

the drain diffusion of the first data storage transistor of each cell being formed in common with the drain diffusion of the first enabling transistor of each cell;

the source diffusion of the second data storage transistor of each cell being formed in common with the source diffusion of the second data storage transistor disposed in the contiguous cell of the same row and adjacent column thereby defining a second source supply node;

a second insulating layer deposited over the first insulating layer, the row address lines, gate strips and impedance devices;

a first conductive strip deposited over the second insulating layer and extending transversely with respect to the row address lines across each row of cells, the first conductive strip being electrically connected to each of the first common source supply nodes defined by a plurality of the second groups, the mutually contiguous cells of each of the second groups being disposed in adjacent columns, thereby defining a first source supply line common to each cell in adjacent columns containing the second groups;

a second conductive strip deposited over the second insulating layer and extending across each row of cells substantially parallel to the first conductive strip, the second conductive strip being electrically connected to the common source diffusions of first enabling transistors of contiguous cells in the column thereby defining a common data output line for each of the cells in the column, and also connected to the common impedance node defining a means of providing cell power without a line used only as a power supply;

a third conductive strip deposited over the second insulating layer and extending across each row of cells substantially parallel to the second conductive strip, the second conductive strip being electrically connected to each of the common source diffusions of the second enabling transistors of contiguous cells in the column thereby defining a common data complement output line for each of the cells in the column;

a fourth conductive strip deposited over the second insulating layer and extending across each row of cells of the array and substantially parallel to the third conductive strip, the fourth conductive strip being electrically connected to each of the second source supply nodes of each cell in the column thereby defining a second source supply line common to each cell in the column.

FIG. 1

FIG. 2

FIG. 3

0032608

FIG. 4

FIG. 5

FIG. 6

FIG. 7

FIG. 8

European Patent
Office

**EUROPEAN SEARCH REPORT**

0032608

Application number

EP 80 30 0205

| Category | Citation of document with indication, where appropriate, of relevant passages | Relevant to claim |
|---|---|---|
| | ELECTRONICS, vol. 52, no. 9, April 1979, New York, U.S.A. R.P. CAPECE: "The race heats up in fast static RAMs", pages 125-135 * Pages 125-135, paragraph "MOSTEK goes its own way"; figure 3 * | 1-3,7 |
| D | US - A - 4 125 854 (MOSTEK) * Column 4, line 62 - column 6, line 64; figure 6 * | 1,6,7 |
| | ELECTRONICS, vol. 52, no. 20, 27th September 1979, New York, U.S.A. D. HUFFMAN: "Polysilicon-load RAMs plug into mainframes or microprocessors", pages 131-139 * Pages 132-133, paragraph "Concepts for a dense new RAM" * | 1-3,7 |
| | IBM TECHNICAL DISCLOSURE BULLETIN, vol. 13, np. 7, December 1980, New York, U.S.A. F.H. GAENSSLEN et al.: "Fet memory cell", page 1751 * Page 1751, lines 17-25; figures A and B * | 1,4 |
| | IBM TECHNICAL DISCLOSURE BULLETIN, vol. 13, no. 10, March 1971, New York, U.S.A. U. BAITINGER et al.: "MOS FET storage cell", page 3160     ./. | 1,4 |

**DOCUMENTS CONSIDERED TO BE RELEVANT**

**CLASSIFICATION OF THE APPLICATION (Int. Cl.²)**

G 11 C 11/40
H 01 L 27/02
            27/10
            27/06
H 03 K  3/356

**TECHNICAL FIELDS SEARCHED (Int.Cl.²)**

G 11 C 11/40
            7/00
H 03 K 3/356

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 23-09-1980 | SCHMIDT |

EPO Form 1503.1   06.78

European Patent

Office

## CLAIMS INCURRING FEES

*The present European patent application comprised at the time of filing more than ten claims.*

☐ All claims fees have been paid within the prescribed time limit. The present European search report has been drawn up for all claims.

☐ Only part of the claims fees have been paid within the prescribed time limit. The present European search report has been drawn up for the first ten claims and for those claims for which claims fees have been paid,

namely claims:

☐ No claims fees have been paid within the prescribed time limit. The present European search report has been drawn up for the first ten claims.

## ☒ LACK OF UNITY OF INVENTION

The Search Division considers that the present European patent application does not comply with the requirement of unity of invention and relates to several inventions or groups of inventions,

namely:

```
1) Claims  1-7: Bit line powered RAM cell circuits.
2) Claims  8,9,15: Integration of a RAM cell.
3) Claims  10-14: Layout of a group of RAM cells.
```

☐ All further search fees have been paid within the fixed time limit. The present European search report has been drawn up for all claims.

☐ Only part of the further search fees have been paid within the fixed time limit. The present European search report has been drawn up for those parts of the European patent application which relate to the inventions in respect of which search fees have been paid,

namely claims:

☒ None of the further search fees has been paid within the fixed time limit. The present European search report has been drawn up for those parts of the European patent application which relate to the invention first mentioned in the claims,

namely claims:   1-7.

# EUROPEAN SEARCH REPORT

**European Patent Office**

0032608

Application number

EP 80 30 0205

-2-

## DOCUMENTS CONSIDERED TO BE RELEVANT

| Category | Citation of document with indication, where appropriate, of relevant passages | Relevant to claim |
|---|---|---|
| | * Page 3160, lines 7-13; figure * | |
| | -- | |
| | IBM TECHNICAL DISCLOSURE BULLETIN, vol. 14, no. 12, May 1972, New York, U.S.A. U. BAITINGER et al.: "Monolithic storage cell with FETs", pages 3640,3641 | 1,4 |
| | * Page 3640, lines 1-23; figure * | |
| | -- | |
| A | GB - A - 1 457 423 (NATIONAL RESEARCH DEVELOPMENT) | 1 |
| | * Page 1, line 86 - page 2, line 10; figure 2 * | |
| | -- | |
| A | US - A - 3 541 531 (BELL) | 1 |
| A | IBM TECHNICAL DISCLOSURE BULLETIN, vol. 14, no. 4, September 1971, New York, U.S.A. D.W. KEMERER: "Storage cell using double-threshold field-effect transistors", pages 1077-1078 | 1 |
| | * Page 1077, lines 10-16; figure 1 * | |
| | -- | |
| A | US - A - 4 091 461 (ROCKWELL) | 1 |
| | * Column 1, lines 32-38; figure 2 * | |
| | -- | |
| A | IBM TECHNICAL DISCLOSURE BULLETIN, vol. 17, no. 12, May 1975 ./. | 1 |

**CLASSIFICATION OF THE APPLICATION (Int. Cl. 3)**

**TECHNICAL FIELDS SEARCHED (Int. Cl. 3)**

EPO Form 1503.2  06.78

## DOCUMENTS CONSIDERED TO BE RELEVANT

| Category | Citation of document with indication, where appropriate, of relevant passages | Relevant to claim |
|---|---|---|
| | New York, U.S.A.<br>L.B. FREEMAN et al.: "Four-device static enhancement/depletion memory array cell", pages 3575-3576<br><br>  * Page 3575, lines 1-5; figure 1 *<br><br>  -- | |
| A | IBM TECHNICAL DISCLOSURE BULLETIN, vol. 17, no. 11, April 1975, New York, U.S.A.<br>G.Y. SONODA: "IGFET address powered Schmidt storage cell", page 3337<br><br>  * Page 3337, lines 15-19; figure *<br><br>  -- | 1 |
| A | US - A - 3 530 443 (FAIRCHILD)<br><br>  * Column 7, line 28 - column 8, line 42; column 11, lines 17-68; figures 3,6 *<br><br>  -- | 1 |
| A | US - A - 3 969 708 (IBM)<br><br>  * Column 2, lines 34-51; figures 1,2 *<br><br>  -- | 1 |
| A | US - A - 3 949 385 (IBM)<br><br>  * Column 2, lines 6-9; figure 1 *<br><br>  -- | 1 |
| A | US - A - 3 540 007 (BELL)<br><br>  * Column 4, lines 20-69 *<br><br>  --       ./. | 1 |

**CLASSIFICATION OF THE APPLICATION (Int. Cl. 3)**

**TECHNICAL FIELDS SEARCHED (Int. Cl. 3)**

**European Patent
Office**

**EUROPEAN SEARCH REPORT**

0032608

Application number

EP 80 30 0205
-4-

| DOCUMENTS CONSIDERED TO BE RELEVANT | | | CLASSIFICATION OF THE APPLICATION (Int. Cl. 3) |
|---|---|---|---|
| Category | Citation of document with indication, where appropriate, of relevant passages | Relevant to claim | |
| A | IBM TECHNICAL DISCLOSURE BULLETIN, vol. 17, no. 7, December 1974, New York, U.S.A. J.R. CAVALIERE et al.: "Writable array-logic cell", pages 1967-1968<br><br>* Page 1968, lines 10,11,27-30; figure *<br><br>-- | 1 | |
| A | ELECTRONICS, vol. 50, no. 10, May 1975, New York, U.S.A. S. YOUNG: "Uncompromising 4-K static RAM runs fast on little power", pages 99-103<br><br>& DE - A - 2 751 481 (MOSTEK) (8th June 1978)<br><br>-- | 1 | **TECHNICAL FIELDS SEARCHED (Int. Cl. 3)** |
| A | EP - A - 0 002 364 (FUJITSU) (13th June 1979)<br><br>---- | 1 | |